# EUROPEAN PATENT APPLICATION

(11) **EP 1 099 779 A1**
(43) Date of publication of application: **16.05.2001**
(21) Application number: 99921161.8
(22) Date of filing: 18.05.1999
(51) Int. Cl.: C23C 16/50, H01L 21/205

(54) **SURFACE TREATMENT APPARATUS**

(30) Priority: 09.07.1998 JP 19467498
(71) Applicant: Komatsu Ltd, Minato-ku, Tokyo 107-8414 (JP)
(72) Inventor: MIZUKAMI, Hiroyuki, Hiratsuka-shi Kanagawa 254-8567 (JP); TAKASHIRI, Masayuki, Hiratsuka-shi Kanagawa 254-8567 (JP); TOYOSHIMA, Yasumasa, Hiratsuka-shi Kanagawa 254-8567 (JP); TABUCHI, Toshihiro, Hiratsuka-shi Kanagawa 254-8567 (JP)
(74) Representative: Stenger, Watzke & Ring Patentanwälte
(86) International application number: JP9902583
(87) International publication number: WO0003065

(57) **Abstract**

The present invention has an object to provide a surface treatment apparatus, which can form a high-quality film at a high speed while preventing deterioration of the film due to collisions of charged particles.

The surface treatment apparatus (1) of the present invention comprises a casing (2) partitioned to two chambers, that is, a plasma generating chamber (3) provided with plasma generating electrodes (5, 5') and a substrate processing chamber (4) provided with a substrate supporting table (8). A plasma vent (6) is formed in the electrode (5') that composes the partition between the chambers (3, 4). A conductive mesh-shaped sheet (9) is disposed in a direction across the plasma between the plasma vent (6) and a substrate (S) on the substrate supporting table (8). The sheet (9), to which a variable bias is applied, captures charged particles in the plasma so that the charged particles can be excluded from the plasma.

## Description

### FIELD OF THE INVENTION

The present invention relates to a surface treatment apparatus, which suits various surface treatments for a substrate, especially a film formation processing for a substrate. More specifically, it relates to a surface treatment apparatus that can reduce the damage occurred by charged particles existing in plasma flow and is capable of forming a high-quality film at a high speed.

### RELATED ART

In a conventional parallel and tabular plasma CVD (Chemical Vapor Deposition) apparatus, a pair of tabular plasma generating electrodes are provided so as to be opposed in parallel to each other in a casing. Of these two plasma generating electrodes, one electrode also functions as a substrate supporting table. Further, this CVD apparatus is provided with a heater for adjusting temperature of the substrate to the temperature that is proper for vapor phase epitaxy. If voltage is applied between the two plasma generating electrodes by a high-frequency electric power supply (13.56 MHz) in a state that the substrate is mounted on said one electrode, the electricity is discharged between these electrodes. With this discharge, plasma is generated and raw gas, for example, monosilane gas, is plasma ionized, so that a silicon film is formed on the surface of the substrate.

In the above described conventional parallel and tabular plasma CVD apparatus, there is an advantage that by enlarging areas of the above tabular plasma generating electrodes, on which the substrate is mounted, it is possible to form a film on a substrate of such a large area by film formation processing at a time. However, in the conventional parallel and tabular plasma CVD apparatus, the raw gas, which is plasma ionized by the two plasma generating electrodes, is diffused evenly in a film-formation gas-processing chamber, so that only part of the gas contributes to the film formation of the substrate mounted on the above electrodes. Therefore, the utilizing efficiency of the raw gas is low. For example, when an amorphous silicon membrane or a microcrystal silicon membrane are intended to be formed on the substrate, the speed of the film formation is low, which is around 0.01 µm/minute, in spite that the inputted electric power is large. Thus, manufacturing of a semiconductor device with a relatively thick film such as a solar battery required a long time, which was the major factor in causing a low throughput and a high cost.

For the purpose of speeding up the film formation, the inputted electric power may be increased by a high-frequency electric power supply. However, electric current inevitably flows between the two plasma generating electrodes. In response to the volume of this electric current, the speed of the charged particles in the plasma is accelerated. These accelerated charged particles directly come into collision with a substrate, which is placed, between the electrodes. The film of the substrate is damaged and deteriorated by that collision of the charged particles. The number of collisions of these charged particles increases in accordance with an increase of the inputted electric power. Therefore, the film of the substrate deteriorates significantly due to the damage by the collisions of the charged particles. Moreover, in accordance with the increase of the high-frequency electric power by the high-frequency electric power supply, a great deal of micropowders generates in the vapor phase. Therefore, the film deteriorates outstandingly due to the micropowders.

Accordingly, in the conventional parallel and tabular plasma CVD apparatus, in order to prevent such a deterioration of the film due to the damage by the collisions of the charged particles and the micropowders, it is inevitable to restrain the inputted electric power (inputted power) to decrease the electric current. In other words, there was practically an upper limit of the inputted electric power and the electric current, so that it was impossible to increase the film formation speed more than a certain level.

On the other hand, according to a reactor, which is disclosed in Japanese Patent Laid-Open Publication No. 63-255373 for example, a casing is partitioned to two chambers, that is, a plasma generating chamber that is surrounded by a pair of opposed plasma generating electrodes connected to a high-frequency electric power supply and an insulating wall and a substrate processing chamber. The plasma generating chamber is provided with an inlet for raw gas. In a center of one of the plasma generating electrodes, there is provided an opening communicating from the plasma generating chamber to the substrate processing chamber. A substrate is supported on a position opposed to the opening of the substrate processing chamber.

In the reactor, when the high-frequency electric power is inputted to the pair of plasma generating electrodes by the high-frequency electric power supply, plasma is generated between the two electrodes, whereby raw gas, which is introduced into the plasma generating chamber, is plasma-ionized. At this time, because the pressure of the substrate processing chamber is set to be lower than that of the plasma generating chamber, the plasma, as a jet flow, is spurted out from the opening defined by the electrodes to the substrate processing chamber, so that it is introduced on the substrate supported so as to be opposed to this opening. Furthermore, according to the reactor, there is provided a magnetic field between the opening and the substrate, parallel to the plasma flow, whereby the plasma flow is further converged and introduced to the substrate.

Thus, in such a reactor that positively blows the plasma flow to the substrate as mentioned above, it is possible to speed up the film formation without increasing the inputted electric power. Moreover, despite of the speed-up of the film formation, crystallization of the membrane is enhanced. Therefore, a high quality membrane can be formed with a higher speed of the film formation than that of the conventional film formation.

According to the above-described reactor, since it is not necessary to place the substrate between the plasma generating electrodes where electric current generate. Thus, it is possible to overcome the problem of a damage due to collisions of charged particles, which is occurred by the electric current. In the meantime, since the numbers of plus charged particles and minus charged particles existing in the plasma are equal, the plasma should be electrically neutral. However, when the electric potential of the plasma flow, which is spurted out in the substrate processing chamber, is measured, it is charged at a plus side. Therefore, there generates a difference in the electric potential between the grounded substrate and the plasma. This electric potential difference accelerates the speed of the charged particles in the plasma. These accelerated charged particles come into collision to a surface of the substrate. Thus, there still exists such a problem that the film of the substrate is deteriorated by the damage caused from the collisions.

The present invention has been made for the purpose of overcoming these problems, an object of which is to provide a surface treatment apparatus that prevents deterioration of a film due to collisions of charged particles and forms a high-quality film at a high speed.

### DISCLOSURE OF THE INVENTION

The present invention is mainly constituted of a surface treatment apparatus for generating plasma by a pair of plasma generating electrodes in a casing having the pair of plasma generating electrodes, a raw-gas inlet and a substrate supporting table, plasma ionizing the raw gas and plasma processing a surface of the substrate, which is mounted on the substrate supporting table, and is characterized in that the casing is partitioned to two chambers, that is, a plasma generating chamber provided with the plasma generating electrodes and a substrate processing chamber provided with the substrate supporting table; the substrate processing chamber communicates with the plasma generating chamber through at least one plasma vent; and charged-particle-excluding means is provided in and between the vicinity of the plasma vent and the vicinity of the substrate supporting table.

Here, the vicinity of the plasma vent includes areas above and below the vent and an inside of the vent. Further, the vicinity of the substrate supporting table includes areas above and below the substrate supporting table and a periphery of its sides.

Thus, by providing the charged-particle-excluding means in and between the vicinity of the plasma vent and the vicinity of the substrate supporting table, it is possible to exclude the charged particles from the plasma before the plasma reaches the substrate. Therefore, the number of the charged particles to collide with the substrate decreases remarkably and the damage due to the collisions decreases. Thus, a high-quality film can be formed on the substrate.

Furthermore, since two chambers, namely the plasma generating chamber and the substrate processing chamber, are defined and the plasma in the plasma generating chamber is spurted from the plasma vent to the substrate, it is possible to speed up the film formation and enhance the crystallization. Therefore, a uniform and high quality film is formed at a high speed. Moreover, by providing a number of plasma vents, it is also possible to form a uniform film even on a substrate having a large area at a high speed.

As the substrate, a glass, an organic film or a metal such as an SUS or the like can be employed. Moreover, though the apparatus of the present invention can be applied to a surface treatment such as etching, it is especially preferable for the apparatus to be used for forming a silicon membrane or a film oxide such as a polycrystalline silicon and an amorphous silicon on the surface of the substrate.

Further, according to the present invention, the high-frequency electric power is inputted in the plasma generating electrodes. Of course, the plasma generating electrodes are connected to a direct current power supply or a high-frequency power supply so that the plasma generating electrodes can be applied with voltage from direct current to high frequency. Especially in the case of generating plasma with the high frequency, it is possible to decrease a great number of the charged particles generating in the plasma. In this case, the inputted power may be between 5 W and 500 W, preferably, between 5 W and 200 W.

Further, according to the present invention, the charged-particle-excluding means is disposed so as to cross the plasma and comprises a conductive member having at least one plasma-passing hole, to which voltage is applied. Furthermore, according to the present invention, the conductive member comprises a mesh-shaped or a grid-shaped conductive sheet. The voltage to be applied to the conductive member is appropriately set in accordance with the value of the power to be inputted in the plasma generating electrodes. When the inputted power is between 5 and 500 W, the voltage to be applied to the conductive member is preferably between - 200 V and + 200 V around, further preferably it is between ± several tens V and ± 100 V.

When minus voltage is applied to the conductive member, the plus charged particles included in the plasma are captured by the conductive member and excluded from the plasma. At this time, repulsive force acts on the minus charged particles so that the minus charged particles are excluded from the plasma. Furthermore, when plus voltage is applied to the conductive member, repulsive force acts between the plus charged particles included in the plasma and the conductive member, so that the plus charged particles jump out of the flow of the plasma and the plus charged particles are excluded from the plasma. At this time, the minus charged particles are captured by the conductive member.

Alternatively, according to the present invention, the charged-particle-excluding means may comprise a pair of electrodes, which are disposed so as to interpose the plasma flow therebetween, which is spurted out from the plasma vent. In this case, the plus charged particles are attracted to the minus electrode side of the electrodes, so that these plus charged particles are excluded from the plasma flow. In the same way, the minus charged particles attracted to the plus electrode side so that they are excluded from the plasma flow.

Further, the charged-particle-excluding means according to the present invention may comprise a magnetic field, in which a line of magnetic force acts in a direction orthogonal to the plasma flow. In this case, a force in the direction, which is orthogonal to the plasma flow, acts upon and moves the plus charged particles by the line of magnetic force, so that the plus charged particles are excluded from the plasma flow. In the same way, the minus charged particles are acted upon by a force in a direction opposite to that of the plus charged particles and are moved to a direction, which is orthogonal to the plasma flow, so that the minus charged particles are excluded from the plasma flow.

The above described conductive member, a pair of opposing electrodes, or the charged-particle-excluding means employing the line of magnetic force may be arranged so as to constitute a part of said plasma vent.

Further, according to the present invention, the plasma vent has a required orifice shape or a nozzle shape. The required orifice shape or a nozzle shape is a shape that can positively draw the plasma in the plasma generating chamber into the vent and diffuse the plasma at a desired angle in the substrate processing chamber so as to discharge the plasma. For example, this may be a columnar shape having a circular section, a circular truncated cone shape, whose diameter expands from the plasma generating chamber to the substrate processing chamber or a combination of these. Furthermore, it may be such a shape that an approximate half of an upstream side thereof has a diameter contracting toward a downstream side and a half of the downstream side thereof has a diameter expanding toward the downstream side. Furthermore, the plasma vent may have a slit shape.

Further, according to the present invention, the raw-gas inlet may open to an inside of the plasma generating chamber. Alternatively, it is possible to be arranged that only carrier gas is to be introduced in the plasma generating chamber and the raw-gas inlet opens to a side face of the plasma vent. In the case that the raw-gas inlet opens to the plasma vent, the raw gas is plasma ionized by the plasma ionized carrier gas, which passes through the vent. In this case, the raw gas does not pollute an inner wall of the plasma generating chamber.

Further, it is possible to give electric potential to the substrate. In that case, it is possible to control energy of the charged particles, which have got through the charged-particle-excluding means and remains in the plasma, so that the damage due to the collisions of the charged particles is extremely reduced.

### BRIEF DESCRIPTION OF THE DRAWINGS

FIG. 1 is a schematic view of a surface treatment apparatus according to a first embodiment of the present invention.
FIG. 2 is a schematic view of a surface treatment apparatus according to a second embodiment of the present invention.
FIG. 3 is a schematic view of a surface treatment apparatus according to a third embodiment of the present invention.
FIG. 4 is a schematic view of a surface treatment apparatus according to a modified example of the third embodiment.
FIG. 5 is a schematic view of a surface treatment apparatus according to a fourth embodiment of the present invention.
FIG. 6 is a schematic view of a surface treatment apparatus according to a fifth embodiment of the present invention.
FIG. 7 is a top view showing an electric field of the surface treatment apparatus in FIG. 6.
FIG. 8 is a schematic view of a surface treatment apparatus according to a sixth embodiment of the present invention.
FIG. 9 is a top view showing a magnetic field of the of the surface treatment apparatus in FIG. 8.
FIG. 10 is a schematic view of a surface treatment apparatus according to a seventh embodiment of the present invention.
FIG. 11 is a schematic view of a main part of a surface treatment apparatus according to an eighth embodiment of the present invention.
FIG. 12 is a schematic view of a main part of a surface treatment apparatus according to a modified example of the eighth embodiment.
FIG. 13 is a schematic view of a main part of a surface treatment apparatus according to a ninth embodiment of the present invention.
FIG. 14 is a schematic view of a main part of a surface treatment apparatus according to a tenth embodiment of the present invention.
FIG. 15 is a schematic view of a main part of a surface treatment apparatus according to an eleventh embodiment of the present invention.
FIG. 16 is a schematic view of a main part of a surface treatment apparatus according to a twelfth embodiment of the present invention.
FIG. 17 is a schematic view of a main part of a surface treatment apparatus according to a modified example of the twelfth embodiment.
FIG. 18 is a schematic view of a main part of a surface treatment apparatus according to a thirteenth embodiment of the present invention.
FIG. 19 is a schematic view of a main part of a surface treatment apparatus according to a modified example of the thirteenth embodiment.
FIG. 20 is a schematic view of a main part of a surface treatment apparatus according to a fourteenth embodiment of the present invention.

### BEST EMBODIMENTS OF THE PRESENT INVENTION

Best embodiments of the present invention will be specifically explained below with reference to the drawings.

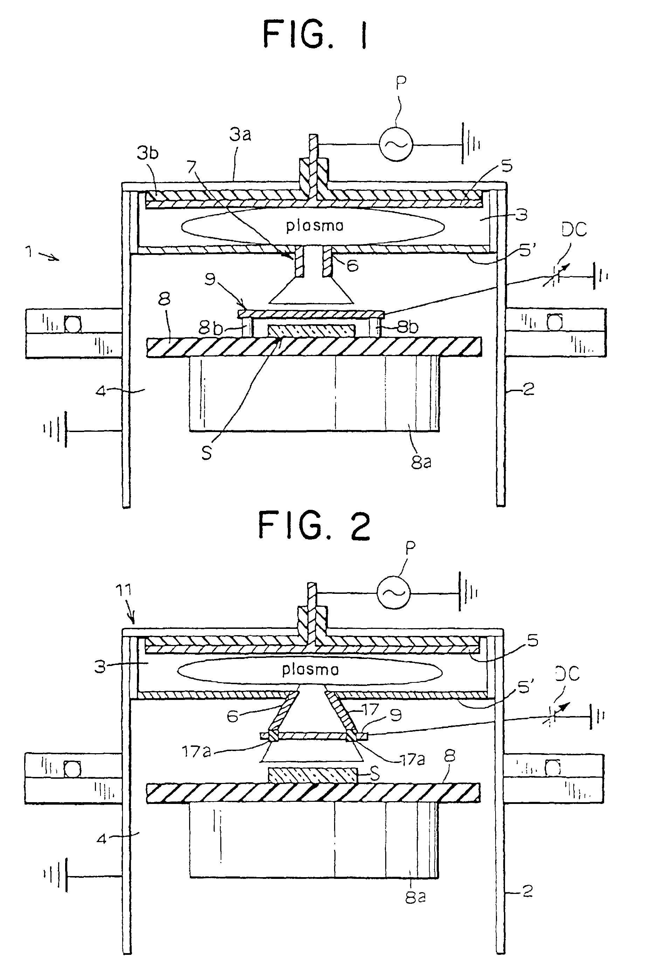

FIG. 1 is a schematic view of a surface treatment apparatus 1 according to a first embodiment of the present invention. In the surface treatment apparatus 1, a grounded casing 2, which intercepts the air from outside, is partitioned to two chambers, that is, a plasma generating chamber 3 and a substrate processing chamber 4. The plasma chamber 3 is provided with a raw-gas inlet (not shown) for introducing raw gas such as monosilane gas or the like. Furthermore, from the raw-gas inlet, carrier gas, which is mixed with the raw gas, is introduced in order to enhance the generation of the plasma, stabilize the plasma and carry the raw gas to a substrate S. An inlet dedicated for the carrier gas may be provided.

Further, a pair of plate-like plasma generating electrodes 5, 5', which are connected to a high-frequency electric power supply P, are disposed in the plasma generating chamber 3. One electrode 5 of the paired two electrodes 5, 5' is attached to an upper wall 3a of the plasma generating chamber 3 via an insulating material 3b. On the other hand, the other electrode 5' constitutes a partition wall with respect to the substrate processing chamber 4. In the center of the electrode 5', which constitutes the partition wall, a plasma vent 6 is formed. As a result, the plasma generating chamber 3 and the substrate processing chamber 4 communicate with each other through the plasma vent 6. Further, the plasma vent 6 is attached with a cylindrical nozzle body 7. By attaching the nozzle body 7 to the plasma vent 6, it is possible to positively introduce plasma in the plasma generating chamber into the plasma vent, so that the plasma can be efficiently diffused at a desired angle in the substrate processing chamber and can be efficiently discharged.

According to the present embodiment, the nozzle body 7 is attached to the plasma vent 6. Alternatively, the plasma vent 6 may be shaped, for example, in such a cylindrical shape that can positively introduce the plasma in the plasma generating chamber into the vent and efficiently diffuse the plasma at a desired angle in the substrate processing chamber to be efficiently discharged as described above or an orifice shape such as a circular truncated cone shape with a head, whose diameter extends toward the substrate processing chamber 4.

In the substrate processing chamber 4, a substrate supporting table 8 is disposed at a position opposing to the plasma vent 6. Since this substrate supporting table 8 is grounded, the substrate S, which is mounted on the substrate supporting table 8, is also grounded. On a lower side of the substrate supporting table 8, a heater 8a is provided for adjusting a temperature of the substrate S mounted on the substrate supporting table 8 to the temperature which is suitable for vapor phase epitaxy.

Further, a conductive sheet 9 in a mesh shape is attached on the substrate supporting table 8 via supporting columns 8b, each of which is composed of an insulating material. A porous conductive sheet such as a grit shape may be used in place of this conductive sheet 9 with a mesh shape. The conductive sheet 9 is disposed in parallel to and above the substrate S, which is mounted on the substrate supporting table 8, so as to cover the substrate S with a gap defined between the conductive sheet 9 and the substrate S. The conductive sheet 9 is connected to a direct current power supply DC. Further, an inside of the substrate processing chamber 4 is adjusted to have an pressure between 0.1 torr to several torrs by a valve, a pressure adjusting valve and a vacuum pump, all of which are not shown.

When high frequency power is inputted in the pair of plasma generating electrodes 5, 5' by a high frequency power supply P, electric discharge is carried out between the plasma generating electrodes 5, 5' and the plasma is generated in the plasma generating chamber 3. With this plasma, the raw gas and the carrier gas, which are introduced into the plasma generating chamber 3, are plasma ionized. At this time, since the pressure in the substrate processing chamber 4 is adjusted to be between 0.1 torr to several torrs, which is lower than the pressure of the plasma generating chamber 3, the plasma in the plasma generating chamber 3 flows out from the nozzle body 7, which is attached to the plasma vent 6, into the substrate processing chamber 4. At this time, the direction of the plasma flow is positively and certainly guided to the substrate S by the nozzle body 7. Depending on this plasma flow, the surface of the substrate S in the substrate processing chamber 4 is plasma processed and a membrane is formed on the surface of the substrate 4.

In this case, as described above, the plasma, which has flown out from the plasma generating chamber 3 to the substrate processing chamber 4, is charged in plus and a electric potential difference is generated between the plasma and the grounded substrate S. Therefore, the plus charged particles in the plasma are accelerated toward the substrate S, so that these plus charged particles collide with the substrate S. As a result, the film of the substrate S deteriorates due to the damage by the collisions. However, according to the present invention, by applying a negative bias to the mesh-shaped conductive sheet 9, which is disposed in parallel with and above the substrate S, that is, which is disposed so as to be orthogonal to the plasma flow, by means of the direct current power supply DC, it is possible that the conductive sheet 9 capture the plus charged particles, so that the plus charged particles are excluded from the plasma flow. Therefore, the number of the charged particles, which come into collision with the substrate S, is extremely decreased. Thus, the deterioration of the film can be efficiently prevented.

Alternatively, it is also possible to apply a positive bias to the conductive sheet 9. In this case, the plus charged particles are bound back from the conductive sheet 9 to jump out from the plasma flow to the outside, so that the plus charged particles are excluded from the plasma flow. The strength of the voltage to be given to this conductive sheet 9 is appropriately set in accordance with the electric power to be inputted in the plasma generating electrodes 5, 5'. For example, if the inputted electric power of the plasma generating electrodes 5, 5' is between 5 W to 500 W, the conductive sheet 9 is applied with the voltage between - 200 and + 200 V around.

The other embodiments and modified examples according to the present invention will be specifically described with reference to the drawings below. In the following description, the same components as those of the above first embodiment are provided with the same reference numerals as those of the first embodiment and their detail descriptions will be omitted.

FIG. 2 is a schematic view of a surface treatment apparatus 11 according to a second embodiment of the present invention. The surface treatment apparatus 11 is provided with the same structure with the surface treatment apparatus 1 according to the above described first embodiment, except for the shape of a nozzle body 17 and the attached position of a mesh-shaped conductive sheet 9.

According to the surface treatment apparatus 11 of the second embodiment, a nozzle body 17, which is attached to a plasma vent 6, has a circular section and has such a truncated cone shape whose diameter extends from a plasma generating chamber 3 toward a substrate processing chamber 4. The mesh-shaped conductive sheet 9, which is connected to a direct current power supply DC, is attached via an insulating material 17a at an end face of the nozzle body 17 on a side toward the substrate processing chamber 4.

Similarly to the above described first embodiment, the surface treatment apparatus 11 of the second embodiment is also provided with a mesh conductive sheet 9 which is disposed orthogonal to the plasma flow. By applying a negative bias to a variable power supply of this conductive sheet 9, it is possible that the plus charged particles are captured by the sheet 9. Alternatively, by applying a positive bias to the sheet 9, it is possible that the plus charged particles are expelled from the plasma flow to the outside, so that the plus charged particles are excluded from the plasma. Therefore, the number of the charged particles, which come into collision with the substrate S, can be extremely reduced, and the deterioration of the film of the substrate S can be efficiently prevented. According to the second embodiment, since the conductive sheet 9 as the charged-particle-excluding means is attached to the end face of the nozzle 17, all the plasma to flow out to the substrate processing chamber 4 pass through the conductive sheet 9. As a result, it becomes possible to exclude the charged particles more reliably and efficiently.

Further, since the nozzle body 17 has a circular truncated cone shape whose diameter expands from the plasma generating chamber 3 toward the substrate processing chamber 4, the plasma diffuses toward the substrate S at a desired angle, so that a film can be formed with a uniform thickness on a surface of the substrate S having a large area.

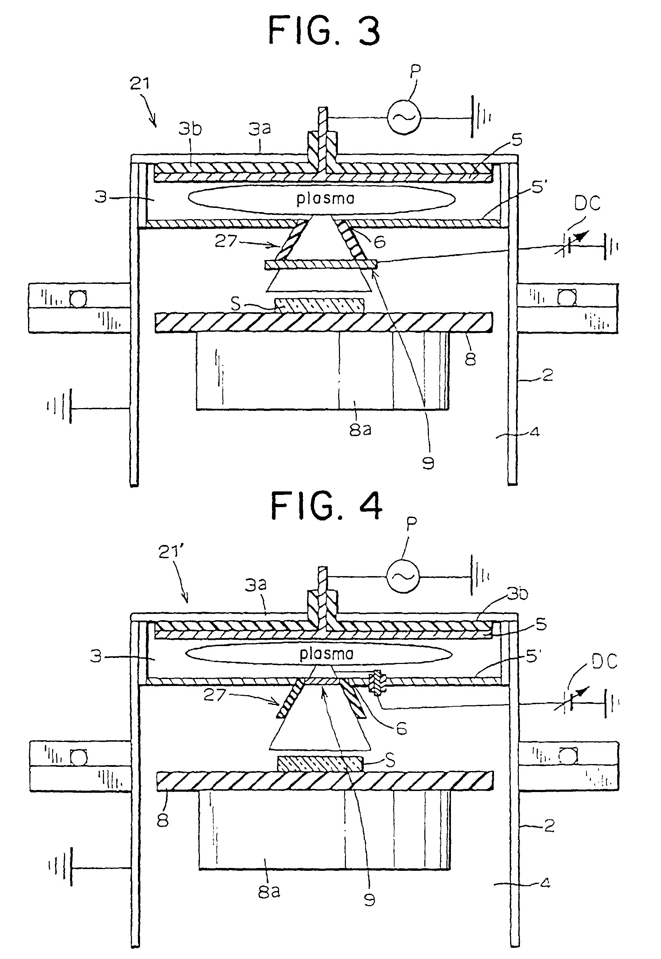

FIG. 3 is a schematic view of a surface treatment apparatus 21 according to a third embodiment of the present invention. The surface treatment apparatus 21 employs a nozzle body 27 composing of an insulating material having the same shape as that of the nozzle body 17 in the above described second embodiment of the present invention. Therefore, a mesh-shaped conductive sheet 9, which is connected to a direct current electric power supply DC, can be directly attached to an end face of the nozzle body 27 on a side toward a substrate processing chamber 4.

In a case where the nozzle 27 composing of the insulating material is employed, the mesh-shaped conductive sheet 9 may be attached to any portions within the nozzle body 27. For example, as in a surface treatment apparatus 21' shown in FIG. 4, the mesh-shaped conductive sheet 9 may be attached to an end face of the nozzle body 27 on a side toward a plasma generating chamber 3.

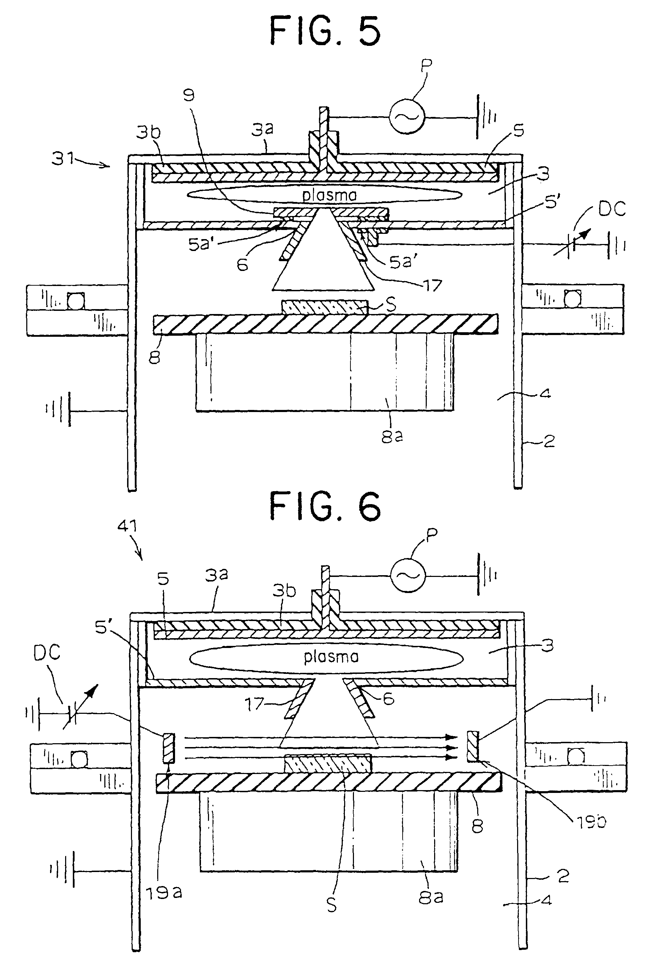

FIG. 5 is a schematic view of a surface treatment apparatus 31 according to a fourth embodiment of the present invention. In the surface treatment apparatus 31, a mesh-shaped conductive sheet 9 is attached in the vicinity of a plasma vent 6 on a side toward a plasma generating chamber 3 so as to cover the vent 6, while an insulating material 5a' is disposed between the conductive sheet and an electrode 5'. In other words, the conductive sheet 9 is disposed so as to be orthogonal to the plasma, which flows out from the plasma vent 6, so that all the plasma, which flow out from the plasma generating chamber 3 to the substrate processing chamber 4, passes through the conductive sheet 9. As a result, the charged particles are excluded.

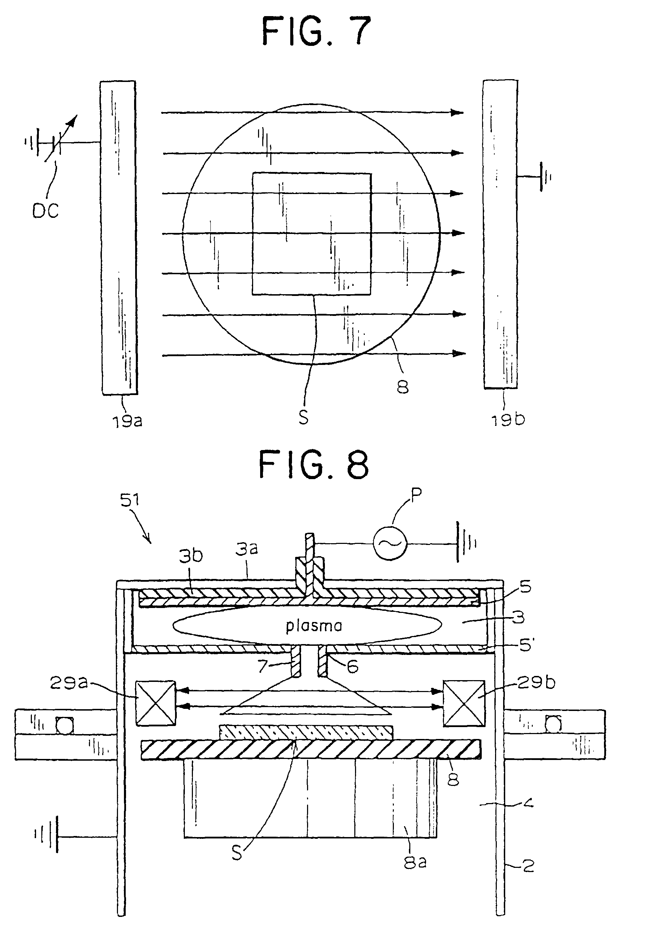

FIGS. 6 and 7 are schematic views of a surface treatment apparatus 41 according to a fifth embodiment of the present invention. In the surface treatment apparatus 41, a pair of opposed electrodes 19a, 19b are disposed so as to interpose a substrate S, which is mounted on a substrate supporting table 8 in a substrate processing chamber 4, namely, interpose the plasma flow, which flows out from a plasma vent 6. These two electrodes 19a, 19b are grounded. Further, one opposed electrode 19a of the two is connected to a direct electric power supply DC. When a plus variable bias is applied to this electrode 19a, an electric field is generated between the two opposed electrodes 19a, 19b in the illustrated direction (from the electrode 19a to the electrode 19b). Due to this electric field, the plus charged particles in the plasma are attracted toward the electrode 19b as a negative electrode and jumps out from the plasma flow. As a result, the plus charged particles are excluded. Therefore, in the same way as the above-described other embodiments, the number of the charged particles which collide with the substrate S is extremely reduced and the deterioration of the film is efficiently prevented. Similarly, the minus charged particles, which are present in the plasma flow, are attracted to the positive electrode to be excluded.

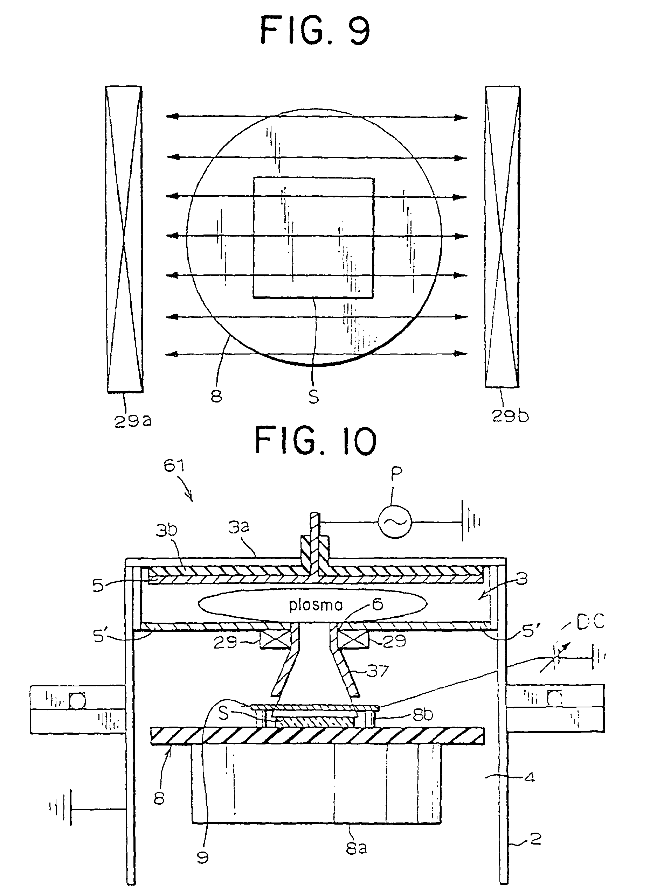

FIGS. 8 and 9 are schematic views of a surface treatment apparatus 51 according to a sixth embodiment of the present invention. In the surface treatment apparatus 51, a pair of permanent magnets 29a, 29b are disposed so as to be opposed to each other, interposing a substrate S, which is mounted on a substrate supporting table 8 in a substrate processing chamber 4. Therefore, a magnetic field of the permanent magnets 29a, 29b occurs such that a line of magnetic force acts in a direction orthogonal to the plasma flow, which flows out from a plasma vent 6, as shown in the Figure. As a result, the plus charged particles in the plasma jump out from the plasma flow to the outside by the line of magnetic force, so that the plus charged particles are excluded. In the same way, the minus charged particles are also excluded in an opposite direction to the plus charged particles. Therefore, in the same way as the above-described other embodiments, the number of the charged particles that collide with the substrate S is extremely reduced and the deterioration of the film is efficiently prevented. It is also possible to use an electromagnet or a superconducting magnet in place of the permanent magnets 29a, 29b.

FIG. 10 is a schematic view of a surface treatment apparatus 61 according to a seventh embodiment of the present invention. In the surface treatment apparatus 61, a nozzle body 37 has a circular section, and approximately a half of an upstream side thereof has a cylindrical shape while a diameter of a half of a downstream side thereof expands toward the downstream side. A pair of electric magnets 29, 29 are disposed so as to be opposed to each other at an end of a substrate processing chamber 4 for attaching the nozzle body 37. A magnetic field of the electric magnets 29, 29 is formed such that a line of magnetic force acts in a direction orthogonal to the plasma flow, which passes through the nozzle body 37. Further, a mesh-shaped conductive sheet 9 is attached on the substrate supporting table 8 via supporting columns 8b, each of which is composed of an insulating material. The sheet 9 is connected to a direct current electric power supply DC, so that the plus or the minus variable bias is applied to the sheet 9.

According to the surface treatment apparatus 61, the plasma in a plasma generating chamber 3 is acted on by the magnetic field of the magnets 29, 29 before passing through the nozzle body 37. Therefore, the plus charged particles in the plasma are attracted to the magnets 29, so that these plus charged particles are excluded from the plasma. Then, from the plasma flown out from the nozzle body 37, the plus charged particles, which remain in the plasma, are excluded by the conductive sheet 9, when the plasma passes through the sheet 9 to which a plus or a minus bias is applied. In this way, in the surface treatment apparatus 61, since the charged particles are reliably excluded from the plasma by the magnets 29, 29 and the conductive sheet 9 at two stages, the number of the charged particles that collide with the forgoing substrate S is extremely reduced and the deterioration of the film is efficiently prevented.

As a nozzle body, besides the nozzle body 37 of the present seventh embodiment and the nozzle bodies 7, 17, 27 having a cylindrical shape or a circular truncated cone shape as described above, it is possible to use a contracting/ expanding nozzle body having such a shape that a diameter of an approximately half of an upstream side thereof contracts toward a downstream side thereof and a diameter of a half of the downstream side thereof expands toward the downstream side. It is preferable that the nozzle body has such a shape that positively pulls in the plasma in the plasma generating chamber 3 and diffuses the plasma at a desired angle in the substrate processing chamber 4 so that the plasma flows out. Especially, a contracting/ expanding nozzle body is preferably used.

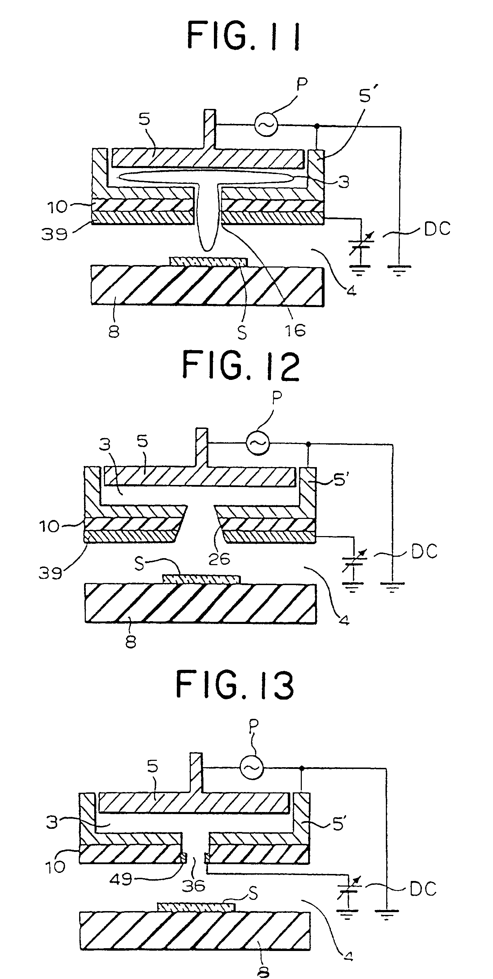

FIG. 11 is a schematic view of a main part of a surface treatment apparatus according to an eighth embodiment of the present invention. In this surface treatment apparatus, a plate-like insulating material 10 is attached on a whole surface of a plasma generating electrode 5' forming a partition wall between a plasma generating chamber 3 and a substrate processing chamber 4, on a side of the substrate processing chamber 4. Further, a conductive plate 39 is attached on a lower face of the insulating material 10 in a laminate manner. The conductive plate 39 is connected to a direct current electric power supply DC and a variable bias is applied to the conductive plate. Further, at a center of the three layers of the electrode 5', the insulating material 10 and the conductive plate 39, a plasma vent 16 having an orifice shape with a circular section is formed.

In this surface treatment apparatus according to the eighth embodiment, the conductive plate 39 comprises a part of the plasma vent 16. When the plasma passes through the plasma vent 16, the plus charged particles are captured by the conductive plate 39, which is applied with the minus variable bias. In this manner, since the plus charged particles are excluded from the plasma, the number of the charged particles that collide with the forgoing substrate S is extremely reduced and the deterioration of the film is efficiently prevented due to the damage of the collisions of the charged particles.

FIG. 12 shows a modified example of the above described eighth embodiment. In FIG. 12, at a center of an electrode 5', an insulating material 10 and a conductive plate 39, which are laminated in three layers, there is formed a plasma vent 26 in an orifice shape of a circular truncated cone, having a circular section, whose diameter gradually expands from a plasma processing chamber 3 to a substrate processing chamber 4. Making the orifice section into the above shape allows the plasma to be diffused to a substrate S at a desired angle. Even when the substrate S has a large area, a film with an even thickness can be formed on a surface of the substrate.

FIG. 13 is a schematic view of a main part of a surface treatment apparatus according to a ninth embodiment of the present invention. In this surface treatment apparatus, a plate-like insulating material 10 is attached on a whole surface of a plasma generating electrode 5' forming a partition wall between a plasma generating chamber 3 and a substrate processing chamber 4, on a side of the substrate processing chamber 4, in a laminate manner. At a center of the electrode 5' and the insulating material 10, which are laminated in two layers, a plasma vent 36 having an orifice shaped with a circular section is formed. Further, a conductive member 49 in a ring shape is attached on a peripheral face of the plasma vent 36 of the plate-like insulating material 10. This conductive member 49 with a ring shape is connected to a direct current electric power supply DC and a variable bias is applied to the conductive member.

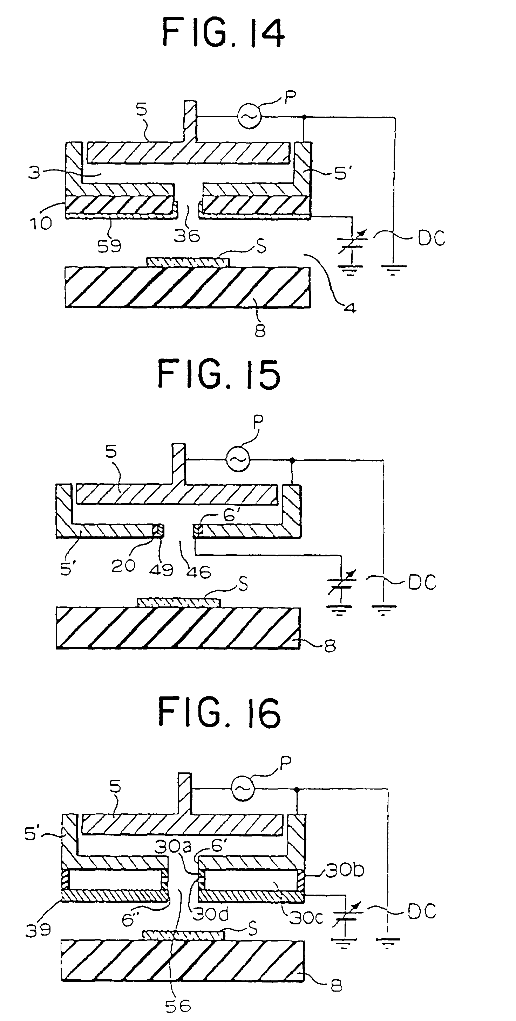

FIG. 14 is a schematic view of a main part of a surface treatment apparatus according to a tenth embodiment of the present invention. Also in this surface treatment apparatus, a plate-like insulating material 10 is attached on a whole surface of a plasma generating electrode 5' forming a partition wall between a plasma generating chamber 3 and a substrate processing chamber 4, on a side of the substrate processing chamber 4, in a laminate layer. At a center of the electrode 5' and the insulating material 10, which are laminated in two layers, a plasma vent 36 having an orifice shape with a circular section is formed. Further, a conductive member 59 in a thin-film-like shape is attached on a lower face of the plate-like insulating material 10 and a peripheral face of the plasma vent 36 at the insulating material 10 by applying galvanizing material or a paste material, so that the conductive member is integrally attached on the insulating material 10. Moreover, this conductive member 59 is connected to a direct current electric power supply DC and a variable bias is applied to the conductive member.

Also in the surface treatment apparatuses of these ninth and tenth embodiments, each of the conductive members 49 and 59 comprises a part of the plasma vent 36 in the same way as the above described eighth embodiment. Therefore, when the plasma passes through the plasma vent 36, the plus charged particles are captured by the conductive members 49, 59, to which the minus variable bias are applied. Thus, the plus charged particles are excluded from the plasma, so that the number of the charged particles which collide with the forgoing substrate S is extremely reduced and the deterioration of the film is efficiently prevented due to the damage of collisions of the charged particles with the substrate S.

FIG. 15 is a schematic view of a main part of a surface treatment apparatus according to an eleventh embodiment of the present invention. In this surface treatment apparatus, an opening 6' is formed at a center of a plasma generating electrode 5' forming a partition wall between a plasma generating chamber 3 and a substrate processing chamber 4. An insulating ring 20 is attached on an inner peripheral face of this opening. Further, a conductive member 49 in a ring shape, which is connected to a direct current electric power supply DC, is attached to an inner peripheral face of this ring 20, so that an inner peripheral face of this conductive member 49 comprises a plasma vent 46. Therefore, in the plasma, which passes through this plasma vent 46, the plus charged particles are captured by the conductive member 49 with a ring shape, to which the minus variable bias is applied.

FIG. 16 is a schematic view of a main part of a surface treatment apparatus according to a twelfth embodiment of the present invention. In this surface treatment apparatus, down below a plasma generating electrode 5' forming a partition wall between a plasma generating chamber 3 and a substrate processing chamber 4, a conductive plate 39 is attached via an inner side peripheral wall portion 30a and an outer side peripheral wall portion 30b, which are composed of insulating materials. Inner peripheral faces of openings 6', 6'', which are formed at a center of the electrode 5' and the conductive plate 39, and the inner side peripheral wall portion 30a comprise circular shapes having the same diameters and they composes a plasma vent 56 having a columnar orifice shape.

Raw gas is filled in a space 30c, which is blocked by the electrode 5', the inner side peripheral wall portion 30a, the outer side peripheral wall portion 30b and the conductive plate 39. Further, a plurality of raw-gas inlets 30d are formed on the inner side peripheral wall portion 30a so as to communicate with the plasma vent 56. The raw-gas inlet 30d may have a slit shape, which is continuously formed along a whole circumference of the inner side peripheral wall portion 30a.

In this surface treatment apparatus, the raw gas is not introduced in the plasma generating chamber 3 but only carrier gas is introduced into the plasma generating chamber 3. When high-frequency electric power is inputted in a pair of plasma generating electrodes 5, 5' by means of a high-frequency electric power supply P, electricity is discharged between the electrodes 5, 5' and the plasma occurs in the plasma generating chamber 3. With this plasma, the carrier gas, which is introduced in the plasma generating chamber 3, is plasma ionized and flows out from the plasma vent 56 into the substrate processing chamber 4.

At this time, the raw gas is introduced from the raw-gas inlet 30d, which opens to a side face of the vent 56, to the plasma flowing through the vent 56. This raw gas is decomposed by the energy owned by the carrier gas, which is plasma ionized, so that the raw gas is plasma ionized. Further, from the plasma flowing through the vent 56, the plus charged particles are excluded by the conductive plate 39, to which the minus charged particles are applied.

Thereafter, the plasma flows out from the plasma vent 56 to the substrate processing chamber 4 to act on a substrate S, which is mounted on a substrate supporting table 8. Then a surface of the substrate S is plasma processed. At this time, since the number of the plus charged particles that are present in the plasma is extremely reduced, the substrate S is less damaged by the collisions of these charged particles. Therefore, a high-quality film can be formed on the surface of the substrate S. Furthermore, according to the present invention, by introducing the raw gas not into the plasma generating chamber 3 but into a middle of the plasma vent 56, it is possible to prevent any pollution on the inner wall of the plasma generating chamber 3 due to the raw gas.

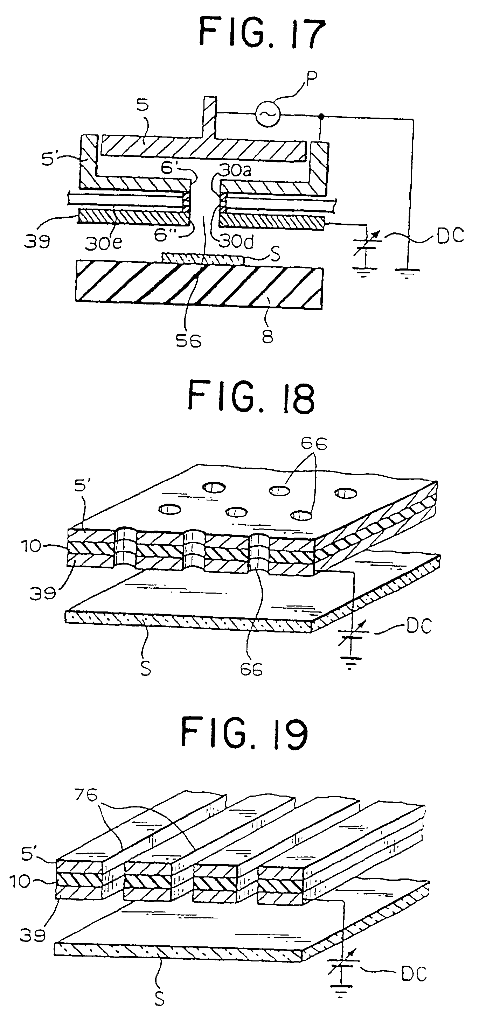

FIG. 17 is a schematic view of a main part of a surface treatment apparatus according to a modified example of the twelfth embodiment, in which a conductive plate 39 is attached down below a plasma generating electrode 5' through an inner peripheral wall 30a, which is composed of an insulating material. Inner peripheral faces of openings 6', 6'', which are formed at a center of the electrode 5' and the conductive plate 39, and the inner side peripheral wall portion 30a comprise circular shapes having the same diameters and they composes a plasma vent 56 having a columnar orifice shape. Further, a plurality of raw-gas inlets 30d are formed on the inner side peripheral wall portion 30a, and a raw gas supply pipe 30e is coupled to each of the inlets 30d. In this modified example, supplying pressure of the raw gas can be easily adjusted by a valve (not shown), which is attached to the pipe 30e.

In any of the above-described embodiments and modified examples, the substrate S is mounted on the fixed substrate supporting table 8. Alternatively, the surface of the substrate supporting table 8 on which the substrate is to be mounted may comprise, for example, a belt conveyor, so that the plasma processing can be carried out on the surface of the substrate S while the substrate S is being moved in a direction orthogonal to the plasma flow. In this case, it becomes possible to carry out a film formation on the substrate S having a relatively large area.

Alternatively, in order to carry out a film formation on a substrate S having a relative large area, for example, as in a thirteenth embodiment in FIG. 18, a plurality of plasma vents 66 each having a nozzle shape with a circular section may be formed on an electrode 5', an insulating material 10 and a conductive plate 39, which are laminated in three layers. Further, as shown in FIG. 19, a plurality of plasma vents 76 each having a slit shape may be formed on an electrode 5', an insulating material 10 and a conductive plate 39, which are laminated in three layers.

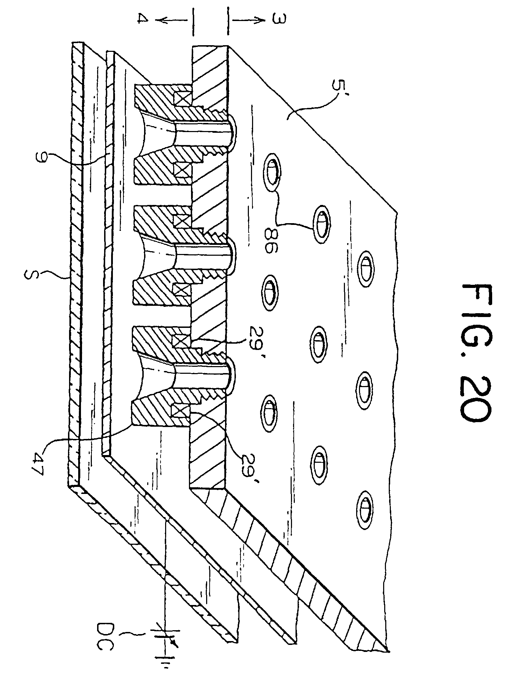

Further, FIG. 20 schematically shows a main part of a surface treatment apparatus according to a fourteenth embodiment of the present invention. In the surface treatment apparatus, a plurality of plasma vents 86 are formed on a plasma generating electrode 5' composing a partition wall between a plasma generating chamber 3 and a substrate processing chamber 4. A nozzle body 47 having a flow path with a column shape at an upper half thereof and a circular truncated cone shape at a lower half thereof is attached to each of the inlets 86. Further, in each of the inlets 86, a pair of permanent magnets 29, 29' are disposed so as to be opposed to each other in the vicinity of a lower face of the plasma generating electrode 5'. With this arrangement, a magnetic field of the permanent magnets 29, 29' is formed such that a line of magnetic force acts in a direction orthogonal to the plasma flow, which passes through the nozzle body 47. Further, a mesh-shaped conductive sheet 9 is attached on the substrate supporting table 8 via supporting columns each composed of an insulating material. The sheet 9 is connected to a direct current electric power supply DC and the plus variable bias or the minus variable bias is applied to the sheet.

According to the surface treatment apparatus, the charged particles are certainly excluded from the plasma, which is in the plasma generating chamber 3, at two stages, at first by the magnetic field of the magnets 29', 29' when the plasma passes through the nozzle body 47 and then by the conductive sheet 9 after the plasma is spurted out from the nozzle body 47. Therefore, the number of the charged particles that collide with the forgoing substrate S is extremely reduced and the deterioration of the film is more efficiently prevented.

Further, according to any of the above described embodiments and modified examples, the substrate S is grounded. However, by giving electric potential to the substrate S, it is possible for the plasma to have an equal electric potential of the plasma from which the charged particles are excluded. In this case, since there is no difference in electric potential between the substrate S and the plasma, the charged particles in the plasma are not accelerated, so that the damage due to the collisions of the charged particles can be extremely reduced.

Further, according to any of the above described embodiments and modifications, the high-frequency electric power is inputted in the plasma generating electrodes by the high-frequency electric power supply P. Alternatively, it is possible to apply voltage direct current by a direct voltage source.

### INDUSTRIAL APPLICABILITY

As described above, the surface treatment apparatus according to the present invention comprises an apparatus for applying a surface treatment such as etching and film formation on a substrate such as a glass, an organic film, or a metal such as an SUS or the like. Especially, it is preferable to use the apparatus of the present invention as an apparatus for forming a silicon membrane and a film oxide such as polycrystalline silicon and amorphous silicon on the surface of the substrate.

## Claims

1. A surface treatment apparatus for generating plasma by a pair of plasma generating electrodes in a casing having said pair of plasma generating electrodes, a raw-gas inlet and a substrate supporting table, plasma ionizing the raw gas and plasma processing a surface of said substrate, which is mounted on said substrate supporting table; characterized in that
said casing is partitioned to two chambers, that is, a plasma generating chamber provided with said plasma generating electrodes and a substrate processing chamber provided with said substrate supporting table;
said substrate processing chamber communicates with said plasma generating chamber through at least one plasma vent; and
charged-particle-excluding means is provided in and between the vicinity of said plasma vent and the vicinity of said substrate supporting table.

2. A surface treatment apparatus according to claim 1, wherein high-frequency electric power is inputted to said plasma generating electrodes.

3. A surface treatment apparatus according to claim 1 or claim 2, wherein said charged-particle-excluding means is disposed so as to cross said plasma and comprises a conductive member having at least one plasma passing hole, to which voltage is applied.

4. A surface treatment apparatus according to claim 3, wherein said conductive member comprises a mesh-shaped or a grid-shaped conductive sheet.

5. A surface treatment apparatus according to claim 1 or claim 2, wherein said charged-particle-excluding means comprises a pair of electrodes that are disposed so as to interpose plasma flow, which is spurted from said plasma vent, therebetween.

6. A surface treatment apparatus according to any one of claims 1 to 5, wherein said charged-particle-excluding means comprises a magnetic field, in which a line of magnetic force acts in a direction orthogonal to said plasma flow.

7. A surface treatment apparatus according to any one of claims 1 to 6, wherein said plasma vent has a required orifice shape or a nozzle shape.

8. A surface treatment apparatus according to any one of claims 1 to 7, wherein said raw-gas inlet defines an opening on a side face of said plasma vent.

9. A surface treatment apparatus according to claim 3 or claim 6, wherein said charged-particle-excluding means constitutes a part of said plasma vent.

10. A surface treatment apparatus according to claim 1, wherein said plasma vent has a circular section.

11. A surface treatment apparatus according to claim 1, wherein said plasma vent has a slit shape.

12. A surface treatment apparatus according to claim 1 wherein said substrate is given with electric potential.
